# EUROPÄISCHE PATENTSCHRIFT

(11) **EP 2 288 796 B1**
(45) Veröffentlichungstag und Bekanntmachung des Hinweises auf die Patenterteilung: **28.12.2011**
(21) Anmeldenummer: 09745744.4
(22) Anmeldetag: 13.05.2009
(51) Int. Cl.: F01N 3/20, F01N 3/28, F01N 5/02, H01L 35/30, H01L 35/32

(54) **VORRICHTUNG ZUR ERZEUGUNG ELEKTRISCHER ENERGIE AUS ABGASWÄRME**
DEVICE FOR PRODUCING ELECTRICAL ENERGY FROM EXHAUST GAS HEAT
DISPOSITIF DE PRODUCTION D'ÉNERGIE ÉLECTRIQUE À PARTIR DE LA CHALEUR DE GAZ D'ÉCHAPPEMENT

(30) Priorität: 16.05.2008 DE 102008023937
(43) Veröffentlichungstag der Anmeldung: 02.03.2011
(73) Patentinhaber: Emitec Gesellschaft für Emissionstechnologie mbH, 53797 Lohmar (DE)
(72) Erfinder: BRÜCK, Rolf, 51429 Bergisch Gladbach (DE); HODGSON, Jan, 53840 Troisdorf (DE); LIMBECK, Sigrid, 53804 Much (DE); SCHATZ, Axel, 50999 Köln (DE)
(74) Vertreter: Rössler, Matthias
(86) Internationale Anmeldenummer: PCT/EP2009/055744
(87) Internationale Veröffentlichungsnummer: WO 2009/138412

(56) Entgegenhaltungen:
- WO-A-2004/059139
- JP-A- 10 234 194
- JP-A- 11 036 981
- US-A1- 2005 172 993

## Beschreibung

Die vorliegende Erfindung betrifft eine Vorrichtung zur Erzeugung elektrischer Energie aus dem Abgas einer Verbrennungskraftmaschine mittels eines Generators. Damit ist insbesondere ein Generator zur Umwandlung thermischer Energie eines Abgases in elektrische Energie gemeint, also ein sogenannter thermoelektrischer Generator.

Abgas aus einem Motor eines Kraftfahrzeugs besitzt thermische Energie, welche mittels eines thermoelektrischen Generators in elektrische Energie umgewandelt werden soll, um beispielsweise eine Batterie oder einen anderen Energiespeicher zu füllen oder elektrischen Verbrauchern die benötigte Energie direkt zuzuführen. Damit steht für den Betrieb des Kraftfahrzeugs Energie in größerem Umfang zur Verfügung.

Ein solcher thermoelektrischer Generator weist zumeist eine Mehrzahl thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des Seebeck-Effekts und ein Phänomen, welches mit Wärmeadsorbtion einhergeht und in Relation zu einem Stromfluss durch unterschiedliche Materialien verursacht wird. Der Peltier-Effekt ist beispielsweise zum thermoelektrischen Kühlen bereits vorgeschlagen worden.

Solche thermoelektrischen Wandlerelemente weisen bevorzugt eine Vielzahl von thermoelektrischen Elementen auf, die zwischen einer so genannten "Warmseite" und einer so genannten "Kaltseite" positioniert sind. Thermoelektrische Elemente umfassen z.B. wenigstens 2 Halbleiterquader (p- und n-dotiert), die auf ihrer Ober- und Unterseite (hin zur "heißen Seite" bzw. "kalten Seite") wechselseitig mit elektrisch leitenden Brücken verbunden sind. Keramikplatten bzw. -beschichtungen und/oder ähnliche Materialien dienen zur Isolierung der Metallbrücken und sind somit bevorzugt zwischen den Metallbrücken angeordnet. Wird ein Temperaturgefälle beidseits der Halbleiterquader bereit gestellt, so bildet sich ein Spannungspotential. Auf der einen Kontaktstelle wird dabei Wärme aufgenommen ("Warmseite"), wobei die Elektronen der einen Seite auf das energetisch höher liegende Leitungsband des folgenden Quaders gelangen. Auf der anderen Seite können die Elektronen nun Energie freisetzen um wieder auf die andere Seite mit niedrigerem Energieniveau zu gelangen ("Kaltseite"). Somit kann sich bei einem entsprechenden Temperaturgefälle ein Stromfluss einstellen.

Es ist bereits versucht worden, entsprechende thermoelektrische Generatoren für die Anwendung in Kraftfahrzeugen, insbesondere Personenkraftfahrzeugen, bereitzustellen. Diese waren jedoch meist sehr teuer in der Herstellung und gekennzeichnet durch einen relativ geringen Wirkungsgrad. Damit konnte noch keine Serientauglichkeit erlangt werden.

Die US 2005/172993 A1 zeigt eine Anordnung von thermoelektrischen Elementen auf der Umfangsfläche einer Abgasleitung. Die thermoelektrischen Elemente sind beweglich gegenüber einer Kühleinrichtung ausgeführt.

JP 11-036981 A und JP 10-234194 A offenbaren ebenfalls die Anordnung thermoelektrischer Elemente auf der Umfangsfläche einer Abgasleitung. Die thermoelektrischen Elemente sind zwischen der Abgasleitung und einer die Abgasleitung umgebenden Kühleinrichtung eingeklemmt.

Aus WO 2004/059139 A1 geht eine Anordnung von Abgasleitung und thermoelektrischen Elementen hervor, wobei die Abgasmenge, die den thermoelektrischen Elementen zugeführt wird, regelbar ist. Auch hier sind die thermoelektrischen Elemente auf einer Umfangsfläche der Abgasleitung angeordnet.

Aufgabe der vorliegenden Erfindung ist es demnach, die mit Bezug auf den Stand der Technik geschilderten Probleme zumindest teilweise zu lösen. Insbesondere soll ein thermoelektrischer Generator angegeben werden, der einen verbesserten Wirkungsgrad hinsichtlich der Umwandlung von bereitgestellter thermischer Energie in elektrische Energie ermöglicht und insbesondere auch den wechselnden Beanspruchungen im Abgassystem mobiler Verbrennungslmaftmaschinen gewachsen ist.

Diese Aufgaben werden mit einer Vorrichtung gemäß den Merkmalen des Patentanspruchs 1 gelöst. Vorteilhafte Ausgestaltungen der erfindungsgemäßen Vorrichtung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die erfindungsgemäße Vorrichtung zur Erzeugung von elektrischer Energie aus dem Abgas einer Verbrennungskraftmaschine umfasst einen Generator mit einem Abgaseintrittsstutzen und einem Abgasaustrittsstutzen sowie zumindest einem Wärmeaustauschabschnitt dazwischen, wobei der Wärmeaustauschabschnitt zumindest ein Wärmeaustauschaggregat aufweist, das mit wenigstens einem thermoelektrischen Element und einer Kühleinrichtung ausgeführt ist, wobei das wenigstens eine thermoelektrische Element mit der Kühleinrichtung unverlierbar verbunden ist.

Erfindungsgemäß ist der Wärmeaustauschabschnitt mit einer Vielzahl von Strömungspfaden quer zum Abgaseintrittsstutzen ausgeführt, die mehreren Wärmeaustauschaggregaten zuordenbar sind, wobei zumindest ein Teil der Wärmeaustauschaggregate mit wenigstens einem thermoelektrischen Element und einer Kühleinrichtung ausgeführt ist und wobei die strömungspfade und die thermoelektrischen Elemente radial angeordnet sind.

Bei dieser Vorrichtung handelt es sich insbesondere um einen so genannten thermoelektrischen Generator. Der Abgaseintrittsstutzen und der Abgasaustrittsstutzen können insbesondere als Teil einer Abgasanlage oder eines Abgasrohres ausgeführt sein. Es ist aber auch möglich, dass mehrere Abgaseintrittsstutzen und/oder mehrere Abgasaustrittsstutzen vorgesehen sind. Kernstück des Generators ist der Wärmeaustauschabschnitt. Damit ist insbesondere ein Teil des Strömungsweges des Abgases durch den Generator gemeint, in dem das Abgas thermische Energie an die Wärmeaustauschaggregate abgibt. Es ist möglich, dass das Abgas auf dem Weg durch den Generator mehrerer solcher Wärmeaustauschabschnitte durchläuft, bevorzugt ist jedoch die Variante, bei dem das Abgas nur einen (zusammenhängenden) Wärmeaustauschabschnitt durchläuft.

Darüber hinaus wird angegeben, dass das Abgas vor dem Eintritt in den Wärmeaustauschabschnitt insbesondere umgelenkt und aufgeteilt wird. Das bedeutet beispielsweise, dass das Abgas durch die Abgasleitung bzw. den Abgaseintrittsstutzen und/oder den Abgasaustrittsstutzen mit einer Hauptströmungsrichtung strömt, für den Durchtritt durch den Wärmeaustauschabschnitt allerdings eine (komplette) Lenkung des Abgases erforderlich ist. Dabei ist bevorzugt, dass eine Umlenkung schräg bzw. quer zu dieser Hauptströmungsrichtung erfolgt, so dass die gesamte Abgasströmung in Umfangsrichtung verteilt wird. Dabei bilden sich Abgasteilströmungen, die insbesondere verschiedenen, zum Teil sogar entgegen gesetzten Strömungsrichtungen folgen. Um nunmehr für den Wärmeaustausch möglichst große Kontaktflächen zu bieten, wird eine Aufteilung der Abgasströmung in Strömungspfade und insbesondere kleine Kanäle bewerkstelligt. Strömungspfade können gerichtete und/oder ungerichtete Durchlässe für das Abgas bilden, z.B. infolge einer regelmäßigen und/oder unregelmäßigen Aufteilung des Abgases im Wärmeaustauschabschnitt, wobei generell möglich ist, dass sich diese Abgasteilströmungen innerhalb des Wärmeaustauschabschnitts wieder (mehrfach) miteinander mischen (können). Solche Strömungspfade können insbesondere mit in einen Spalt eingebrachte Stege, Noppen oder dergleichen gebildet sein. Die Kanäle sind bevorzugt klar voneinander abgetrennt (z.B. durch eine fortlaufende Kanalwand). Bei Strömungspfaden und/oder Kanälen kann es aber in besonderen Fällen auch möglich sein, dass die Strömungspfade bzw. Kanäle miteinander über Verbindungskanäle und/oder Öffnungen kommunizieren können. Die Anzahl der Strömungspfade bzw. Kanäle beträgt bevorzugt deutlich mehr als 20, so zum Beispiel mindestens 50 oder sogar mindestens 100 Kanäle. Damit haben die Kanäle einen Öffnungsquerschnitt, der gegenüber dem des Abgaseintrittsstutzens deutlich verkleinert ist, so dass eine deutlich vergrößerte Wärmeaustauschfläche, die von den Wänden der Kanäle gebildet wird, zur Verfügung steht.

Benachbart zu den Strömungspfaden sind bevorzugt ein oder zwei Wärmeaustauschaggregate mit den thermoelektrischen Elementen und der Kühleinrichtung angeordnet. Bevorzugt ist gegebenenfalls, dass die Kanäle an den Wärmeaustauschaggregaten anliegen, also in Wärme leitendem Kontakt sind, Die thermoelektrischen Elemente sind dabei bevorzugt entlang der Kanäle angeordnet, wobei ganz besonders bevorzugt ist, jeweils zumindest ein thermoelektrisches Element über die Länge eines Strömungspfads im Wärmeaustauschabschnitt zu positionieren. Die Kühleinrichtung ist auf der Seite der thermoelektrischen Elemente angeordnet, die den Strömungspfaden abgewandt ist. Dabei sind die thermoelektrischen Elemente mit der Kühleinrichtung unverlierbar verbunden. Das bedeutet insbesondere, dass die thermoelektrischen Elemente nur mit der Kühleinrichtung bzw. einem Teil der Wärmeaustauschaggregate stoffschlüssig verbunden ist. Der Wärme leitende Kontakt hin zu den Strömungspfaden erfolgt daher insbesondere nur über einen Anlagekontakt ohne stoffliche Verbindung. "Unverlierbar" soll in diesem Zusammenhang bedeuten, dass eine Relativbewegung der thermoelektrischen Elemente gegenüber der Kühleinrichtung (ohne Demontage) während des Betriebs der Vorrichtung nicht möglich ist, also die thermoelektrischen Elemente mit der Kühleinrichtung bzw. dem Wärmeaustauschaggregat verschweißt, verlötet, verklebt, verankert, verschraubt, verspannt oder in einer sonstigen Weise sicher befestigt sind.

Gemäß einer vorteilhaften Weiterentwicklung der Vorrichtung ist zwischen Abgaseintrittsstutzen und dem Wärmeaustauschabschnitt mindestens eine Strömungsumlenkung vorgesehen.

Gemäß einer weiteren Weiterentwicklung ist zwischen Abgaseintrittsstutzen und dem Wärmeaustauschabschnitt mindestens eine Strömungsaufteilung vorgesehen.

Gemäß einer bevorzugten Weiterbildung der Vorrichtung sind Abgaseintrittsstutzen und Abgasaustrittsstutzen gegenüberliegend und die Wärmeaustauschaggregate radial dazu angeordnet. Damit können Abgaseintrittsstutzen und Abgasaustrittsstutzen beispielsweise in eine gradlinige, rohrförmige Abgasleitung integriert werden. Die Wärmeaustauschaggregate sind darum radial und senkrecht zu der Abgasleitung angeordnet, so dass das Abgas für die Erzeugung elektrischer Energie aus der Hauptströmungsrichtung radial umgelenkt werden muss, den Wärmeaustauschabschnitt durchtritt und danach wieder ein- und/oder mehrfach umgelenkt werden muss, um in Hauptströmungsrichtung durch den Abgasaustrittsstutzen wieder abzuströmen. Damit lässt sich einerseits ein besonders kompakter Aufbau verwirklichen, außerdem erhöht die Umlenkung eine Turbulenzströmung des Abgases, so dass im nachfolgenden Wärmeaustauschabschnitt eine besonders innige Kontaktierung der Wände der Kanäle und damit ein guter Wärmeübergang hin zu den thermoelektrischen Elementen gewährleistet ist.

Darüber hinaus wird als vorteilhaft angesehen, dass die Wärmeaustauschaggregate und die Kühleinrichtung mit Plattenelementen ausgebildet sind, auf denen das wenigstens eine thermoelektrische Element positioniert ist. So können die Kühlkanäle, durch die beispielsweise eine Kühlflüssigkeit hindurchgeleitet wird, zwischen zwei aufeinander gesetzten Platten ausgebildet sein. Die Kühleinrichtung bzw. die Wärmeaustauschaggregate sind damit relativ stabil und robust, so dass insbesondere ein Austritt der Kühlflüssigkeit verhindert wird. Damit bieten aber die Plattenelemente auch die Möglichkeit der Anbindung der thermoelektrischen Elemente, die bevorzugt auf einer Seite eines Plattenelementes ausgebildet sind, die der Kühleinrichtung abgewandt ist. Damit ist das thermoelektrische Element beispielweise auf der Oberfläche eins Plattenelementes angeordnet, an dem dann auch die Kanäle für die Abgasströmung angeordnet sind. Die Plattenelemente können als Module bereitgestellt und für eine einfache Montage in der gewünschten Form zusammengestellt werden. Damit lässt sich eine relativ kostengünstige Herstellung eines solchen thermoelektrischen Generators verwirklichen.

Insoweit ist es hier besonders vorteilhaft, dass ein solches Plattenelement mit einer internen Kühleinrichtung und thermoelektrischen Elementen an beiden Seiten hin zu den benachbarten Strömungspfaden ausgeführt ist. Die interne Kühleinrichtung kann durch gefräste oder gebohrte oder in sonstiger Weise hergestellter Kühlkanäle gebildet sein, wobei gegebenenfalls (aber nicht bevorzugt) ein zusätzliches Material in die Kanäle eingebracht sein kann. Vorteilhaft ist aber, dass die Plattenelemente selbst aus sehr gut Wärme leitenden Materialien gebildet sind, so dass ein möglichst guter Übergang der erzeugten Wärmeenergie vom Abgas auf die Wärmeaustauschaggregate und damit in die thermoelektrischen Elemente gewährleistet wird. Darüber hinaus bieten diese Plattenelemente die Möglichkeit, die elektrischen Leitungen hin zu thermoelektrischen Elementen stabil und geschützt anzuordnen.

In diesem Zusammenhang wird auch vorgeschlagen, dass das Plattenelement mit einer Metallfolie gebildet ist, die mit zumindest einem thermoelektrischen Element versehen und mit einer Schutzschicht überdeckt ist. Die Metallfolie weist dabei gegebenenfalls eine Struktur auf, so dass ein Stapel aus zumindest zwei Metallfolien zwischen sich Kanäle, insbesondere für das Kühlfluid, bildet. Damit hat das Plattenelement eine geringe thermische Masse und ist sehr leicht. Für eine unverlierbare Verbindung zwischen thermoelektrischem Element und der Metallfolie sorgt zudem eine Schutzschicht, die insbesondere den Kontakt von Abgas auf deren Oberseite mit dem bedeckten thermoelektrischem Element verhindert. Die Schutzschicht kann als Beschichtung und/oder als separates Bauteil ausgeführt sein (wie z.B. eine weitere metallische Folie).

Die durch die Stapelung solcher Plattenelemente erzeugten Kanäle, die von dem Abgas durchströmt werden, können ebenfalls durch strukturierte Metallfolien erzeugt werden. Dabei können mehrere Metallfolien aufeinander angeordnet sein, so dass auch Kanäle vorgesehen sein können, die nicht benachbart zu thermoelektrischen Elementen angeordnet sind.

Gemäß einer anderen Ausführungsform der Vorrichtung ist das Wärmeaustauschaggregat als rohrförmiges Element ausgebildet. Das rohrförmige Element ist innen durchströmbar ausgeführt. Das Rohrinnere wird dabei insbesondere als Kühleinrichtung genutzt und wird dazu von einem flüssigen oder gasförmigen Kühlmedium durchströmt. Auf oder an der Rohrwandung des rohrförmigen Elementes ist wenigstens ein thermoelektrisches Element ausgebildet, das mit dem rohrförmigen Element unverlierbar verbunden ist. Das durch das rohrförmige Element gebildete Wärmeaustauschaggregat kann somit innen von einem Kühlmedium und außen von einem Abgas umströmt werden.

Das rohrförmige Element kann dabei einen runden oder auch eckigen Querschnitt aufweisen. Die Anordnung einer Mehrzahl von rohrförmigen Elementen erzeugt die bereits hinsichtlich der Plattenelemente beschriebenen Kanäle zwischen den Wärmeaustauschaggregaten.

Gemäß einer Weiterbildung der Erfindung wird auch vorgeschlagen, dass in dem Wärmeaustauschabschnitt Kompensatoren für Relativbewegungen der Wärmeaustauschaggregate vorgesehen sind. Damit ist insbesondere gemeint, dass im Wärmeaustauschabschnitt Mittel vorgesehen sind, die gegebenenfalls auch eine Relativbewegung der Komponenten des Wärmeaustauschabschnitts zulassen, also beispielsweise eine (minimale) Bewegung der Kanäle mit Abgas gegenüber den Wärmeaustauschaggregaten, insbesondere in Richtung der Hauptströmungsrichtung. Dies muss nicht für alle Wärmeaustauschaggregate gelten, in der Regel sollte ein Kompensator für alle Wärmeaustauschaggregate ausreichend sein. Ein solcher Kompensator kann beispielsweise mit elastisch verformbaren, gegebenenfalls vorgespannten Blechteilen erreicht werden. Als Kompensatoren dienen insbesondere Bauteile, die die Strömungspfade (teilweise) begrenzen, wie z.B. gewellte Metallfolien. Außerdem können z.B. zusätzliche Kompensatoren an den Stirnseiten des Wärmeaustauschabschnitts vorgesehen sein (z.B. ebenfalls mit parallel zu den Plattenelementen angeordneten (gewellten) Metallfolien, die nicht mit Abgas in Kontakt sind).

Gemäß einer Weiterbildung ist der Generator mit einem Katalysatorabschnitt ausgeführt, der zumindest teilweise dem Wärmeaustauschabschnitt vorgelagert ist. Dabei ist ganz besonders bevorzugt, dass das Abgas, das in den Wärmeaustauschabschnitt gelenkt wird, zunächst über den Katalysatorabschnitt strömt und danach den Wärmeaustauschabschnitt erreicht. Ganz besonders bevorzugt ist, dass der Katalysatorabschnitt und der Wärmeaustauschabschnitt vom Abgas entgegengesetzt durchströmt werden. In dem Katalysatorabschnitt ist bevorzugt eine radiale Wabenstruktur vorgesehen, die mit Washcoat und einem Oxidationskatalysator beschichtet ist (Platin bevorzugt). In dem Katalysatorabschnitt wird in Folge der katalytischen Umsetzung von Bestandteilen des Abgases eine exotherme Reaktion in Gang gesetzt, die die thermische Energie im Abgas erhöht. Dieses nun "vorgeheizte" Abgas dient nun zur Generierung einer größeren Menge thermoelektrischer Energie. Der Katalysatorabschnitt kann gegebenenfalls mit verschiedenen Beschichtungen und/oder Katalysatoren ausgeführt sein. Auch ist möglich, den Katalysatorabschnitt hinsichtlich des Kontaktbereichs und/oder des zugeführten Abgases variabel zu gestalten, um so die Temperaturerhöhung gezielt zu regeln. Insbesondere können auch wenigstens Teilbereiche der Kanäle und Wandungen der vom Abgas durchströmten weiteren Bereiche des Generators, insbesondere wenigstens Teilbereiche der Kanäle des Wärmeaustauschabschnittes, mit Washcoat und einem Oxidationskatalysator beschichtet sein. Bevorzugt werden dabei die Bereiche der Kanäle, die unmittelbar an ein thermoelektrisches Element angrenzen nicht mit einer solchen Beschichtung versehen, da hierdurch die Wärmeleitfähigkeit von den Strömungspfaden zu den thermoelektrischen Elementen beeinträchtigt werden kann.

Außerdem wird als vorteilhaft erachtet, dass die Strömungsumlenkung eine im Abgaseintrittsstutzen positionierte Leitstruktur ist. Dabei handelt es sich bevorzugt um eine zentral im Abgaseintrittsstutzen positionierte Leitstruktur. Die Leitstruktur kann beispielsweise nach Art eines Kegels ausgeführt sein. Auch können statische Mischer und dergleichen eingesetzt werden. Unter Umständen ist es vorteilhaft, den Winkel und/oder die axiale Lage der Leitstruktur in dem Abgaseintrittsstutzen zu variieren.

Alternativ und/oder kumulativ dazu kann auch eine selbstregelnde Leitstruktur vorgesehen werden, wie z.B. eine, die bei unterschiedlichen Temperaturen eine unterschiedliche Position bzw. Lage in dem Abgaseintrittsstutzen einnimmt. Hierfür eignet sich insbesondere Bimetall, das zumindest teilweise von dem Abgas umströmbar angeordnet ist. Ein Bimetall (auch Thermobimetall) ist insbesondere ein Metallstreifen aus zwei Schichten unterschiedlichen Materials, die miteinander stoffschlüssig und/oder formschlüssig verbunden sind. Charakteristisch ist die Veränderung der Form bei Temperaturänderung. Diese äußert sich als Verbiegung. Ursache ist der unterschiedliche Wärmeausdehnungskoeffizient der verwendeten Metalle.

Außerdem kann ein solches Bimetall, das zumindest teilweise von dem Abgas umströmbar angeordnet ist, auch zur Steuerung des Betriebs der Vorrichtung und/oder von Teilkomponenten der Vorrichtung herangezogen werden. Beispielswiese kann das Bimetall als Temperatursensor genutzt werden, so dass in Abhängigkeit der Verformung des Bimetalls z.B. die Leitstruktur bedarfsgerecht betätigt wird.

Einer Weiterbildung der Vorrichtung zur Folge ist wenigstens eine einstellbare Strömungsverbindung von Abgaseintrittsstutzen zum Abgasaustrittsstutzen vorgesehen, so dass Abgas zumindest an einem Teil des Wärmeaustauschabschnitts vorbeiströmen kann. Ganz besonders bevorzugt ist diese einstellbare Strömungsverbindung, ein sogenannter Bypass, der eine direkte Verbindung von Abgaseintrittsstutzen und Abgasaustrittsstutzen darstellt, insbesondere mit gleichem Strömungsquerschnitt. Ganz besonders bevorzugt ist, dass diese Strömungsverbindung erlaubt, das gesamte Abgas am gesamten Wärmeaustauschabschnitt vorbeizuführen. Das eröffnet beispielsweise die Möglichkeit, nur in bestimmten Lastzyklen und/oder Betriebsphasen des Motors das Abgas über den Wärmeaustauschabschnitt zu führen und thermoelektrische Energie zu erzeugen. Sollte beispielsweise thermische Energie für die nachfolgende Abgasreinigungskomponenten erforderlich sein, kann also mit der einstellbaren Strömungsverbindung ein vorzeitiger Abtransport der später benötigten Wärme vermieden werden. Mit dem Begriff "einstellbar" soll zum Ausdruck gebracht werden, dass der Umfang, in dem die Strömungsverbindung vom Abgas genutzt wird, geregelt werden kann. Hierzu kommen grundsätzlich bekannte Abgasklappen, Ventile oder dergleichen in Betracht.

Ganz besonders bevorzugt ist, dass die wenigstens eine einstellbare Strömungsverbindung eine federvorgespannte und verschwenkbare Klappe am Einlass der Strömungsverbindung ist. Das bedeutet insbesondere, dass eine Klappe so angeordnet ist, dass eine Feder oder ein sonstiger Mechanismus die Stellung der Klappe regelmäßig so einstellt, dass die Strömungsverbindung geschlossen ist, hier also kein Abgas hindurch treten kann, bzw. nur sehr wenig. Im konkret vorgegebenen Situationen kann die Klappe aktiv durch einen Verstellmechanismus so verschwenkt werden, dass Abgas durch den Einlass der Strömungsverbindung hindurchströmen und damit direkt zum Abgasaustrittsstutzen strömen kann. Es ist aber auch möglich, dass die Klappe eine solche Federvorspannung aufweist, dass sie in Abhängigkeit vom Abgasgegendruck verschwenkt wird. Das heißt mit anderen Worten auch, dass bei besonders hohen Abgasdurchsätzen die Klappe sich automatisch weiter öffnet. Damit kann beispielsweise eine Überhitzung des thermoelektrischen Generators und/oder ein zu hoher Druckverlust für die in diesen Phasen benötigte Motorleistung vermieden werden. Dieser sich selbst regelnde Mechanismus ist besonders einfach und gewährleistet den dauerhaften Betrieb der Vorrichtung.

Außerdem kann auch vorgesehen sein, dass eine Zusatzkühlung für zumindest einen Teil des Wärmeaustauschabschnitts vorgesehen ist. Das heißt beispielsweise, dass ein zweiter Kühlkreislauf bedarfsorientiert zugeschaltet werden kann. Ganz besonders bevorzugt ist die Zusatzkühlung eine Umkehr-Schaltung der thermoelektrischen Elemente, so dass diese als Peltier-Elemente wirken. Damit können sie dann den Wärmeaustauschabschnitt bzw. sich selbst kühlen für den Fall, dass zu heißes Abgas durch den thermoelektrischen Generator strömt.

Die Erfindung findet ganz besonders bevorzugt Anwendung in einem Kraftfahrzeug, insbesondere in einem Personenkraftfahrzeug.

Die Erfindung sowie das technische Umfeld werden anhand der beigefügten schematischen Figuren veranschaulicht. Es ist darauf hinzuweisen, dass die Figuren besonders bevorzugte Ausführungsvarianten zeigen, die Erfindung jedoch nicht darauf beschränkt ist. Es zeigen:
- Fig. 1:: eine erste Variante einer erfindungsgemäßen Vorrichtung,
- Fig. 2:: eine weitere Ausführungsvariante der erfindungsgemäßen Vorrichtung,
- Fig. 3:: ein Detail eines Wärmeaustauschaggregates gemäß einer weiteren Ausführungsvariante der Erfindung,
- Fig. 4:: ein Beispiel einer Metallfolie zum Aufbau eines Wärmeaustauschabschnittes,
- Fig. 5:: einen möglichen Aufbau für ein Wärmeaustauschaggregat in Explosions-darstellung,
- Fig. 6:: schematisch die Integration der erfindungsgemäßen Vorrichtung in einem Kraftfahrzeug,
- Fig. 7:: eine weitere Ausführung der Erfindung mit einem Teilschnitt durch einen oberen Teil der Kühleinrichtung mit einem thermoelektrischen Element, und
- Fig. 8:: ein Detail einer Ausführungsvariante eines Wärmeaustauschaggregates mit einem rohrförmigen Element.

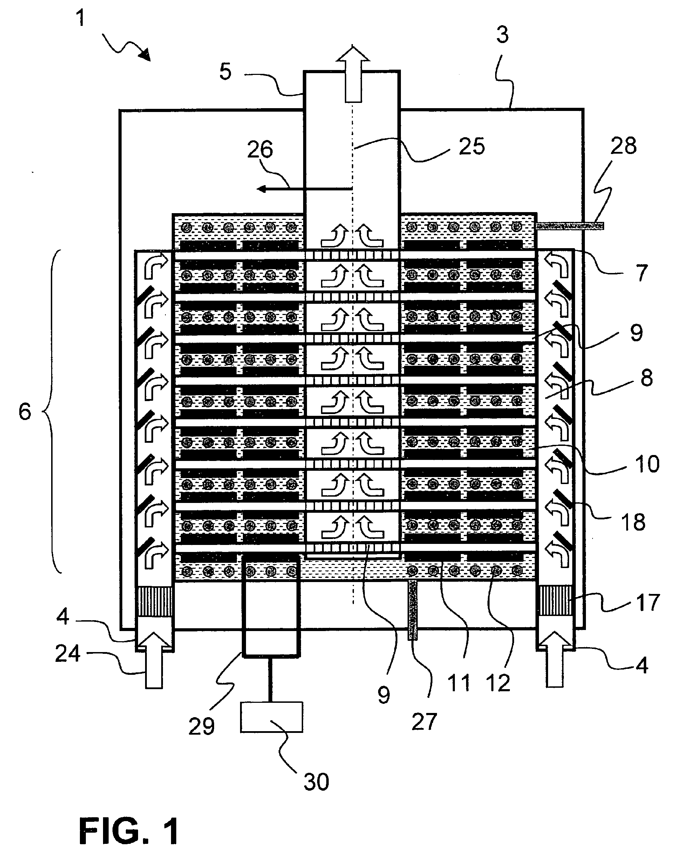

Fig. 1 stellt eine erste Ausführungsvariante einer erfindungsgemäßen Vorrichtung 1 zur Erzeugung elektrischer Energie aus dem Abgas einer hier nicht dargestellten Verbrennungskraftmaschine 2 dar. Die Vorrichtung 1 weist dabei im unteren Bereich eine Art Ringkanal auf, der den Abgaseintrittsstutzen 4 bildet. Wie mit Pfeilen veranschaulicht, strömt dort das gesamte Abgas in den Generator 3 mit der entsprechenden Strömungsrichtung 24 ein. Zu Beginn trifft das Abgas dann auf einen Katalysatorabschnitt 17, der beispielsweise mit einem sogenannten Wabenkörper ausgeführt ist, in dem eine katalytisch aktive Beschichtung vorgesehen ist. Nach Durchtritt dieses Katalysatorabschnitts 17 tritt das Abgas in den Wärmeaustauschabschnitt 6 ein, in dem es anhand einer Vielzahl von im Abgaseintrittsstutzen 4 vorgesehenen Leitstrukturen um 90° radial einwärts strömt. Dabei wird das Abgas in eine Vielzahl von Strömungspfaden 9 umgeleitet, so dass eine Strömungsaufteilung 8 an der Mantelfläche erreicht wird. Dann strömt das Abgas radial einwärts zum zentral angeordneten Austrittsstutzen 5, der hier nur einseitig geöffnet ist (nämlich oben). Demnach tritt das Abgas nun aus den einzelnen Strömungspfaden 9 wieder aus und strömt ab entlang der zentralen Achse 25.

Um die Achse 25 bzw. den Abgasaustrittsstutzen 5 herum sind in radialer Richtung 26 mehrere Wärmeaustauschaggregate 10 angeordnet. Die Wärmeaustauschaggregate 10 umfassen zentral eine Kühleinrichtung 12, durch die ein bevorzugt flüssiges Kühlmittel hindurchströmt, um eine möglichst große Temperaturdifferenz zwischen der Kühleinrichtung 12 einerseits und den mit Abgas durchströmten Strömungspfaden 9 andererseits zu realisieren. Bevorzugt ist, dass jedes Wärmeaustauschaggregat einen separaten Zulauf 27 und Ablauf 28 für das Kühlmittel aufweist, dies ist aber nicht zwingend erforderlich. Zwischen den Strömungspfaden 9 und der Kühleinrichtung 12 sind die thermoelektrischen Elemente 11 vorgesehen, hier mehrere in Reihe, dies ist aber ebenfalls nicht notwendig. Beim Durchströmen der Kanäle 9 wird eine Temperaturdifferenz aufgebaut, die eine Generierung von thermoelektrischer Energie in den thermoelektrischen Elementen 11 zur Folge hat, die hier mit schematisch angedeuteten Stromfaden 29 hin zu einem Speicher 30 verbunden sind.

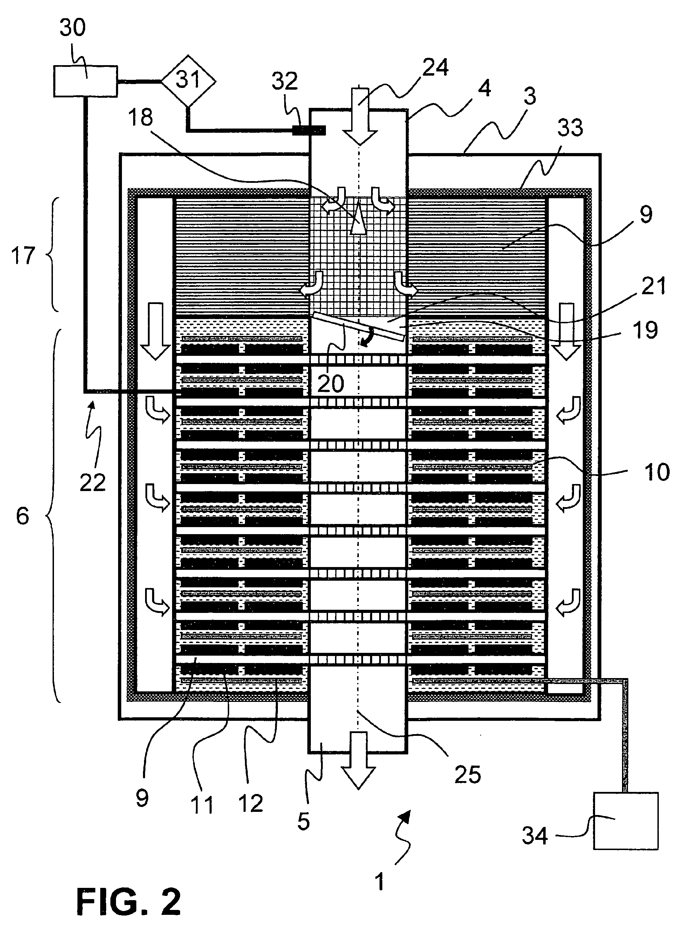

Ein etwas abweichendes Konzept für eine solche erfindungsgemäße Vorrichtung 1 geht aus Fig. 2 hervor. Hier ist die Strömungsrichtung 24 im Wesentlichen von oben nach unten strömend dargestellt. Damit strömt das gesamte Abgas zunächst in den Abgaseintrittsstutzen 4 oben in den Generator 3 ein. Nahe des Eintritts in den Generator 3 ist zentral im Abgaseintrittsstutzen 4 eine konusförmige Leitstruktur vorgesehen, die bereits einen Teil der Abgasströmung motiviert radial auswärts zu strömen. Weiter stromabwärts ist eine Klappe 20 vorgesehen, die für einen vorgegebenen Betriebszustand des Generators 3 den Abgaseintrittsstutzen 4 im Wesentlichen verschließt, so dass (nahezu) das gesamte Abgas nun radial nach außen umgelenkt wird. Dabei tritt das Abgas dann in den Katalysatorabschnitt 17, der beispielsweise nach Art eines radialen Wabenkörpers ebenfalls mit einer Vielzahl von Strömungspfaden 9 ausgeführt ist. Die Kanäle sind mit einer Beschichtung zumindest teilweise versehen, die eine exotherme Reaktion des Abgases zur Folge haben, so dass das Abgas beim Verlassen des Katalysatorabschnitts 17 eine höhere thermische Energie hat. Das Abgas strömt dann in der Fig. 2 weiter nach unten im Ringkanal und wird aufgrund des Verschlusses erneut umgelenkt, diesmal radial einwärts in die Kanäle 9. Um zu gewährleisten, dass ein hohes Maß der thermischen Energie an die Wärmeaustauschaggregate 10 abgegeben wird, ist der Generator 3 mit einer thermischen Isolierung 33 versehen.

Die das Abgas führenden Kanäle 9 weisen im Bereich des Wärmeaustauschabschnittes 6 beidseits jeweils ein Wärmeaustauschaggregat 10 auf. Diese sind in der Regel so aufgebaut, dass intern eine Kühleinrichtung 12 vorgesehen ist und in direkter Nachbarschaft zu den Strömungspfaden 9 die thermoelektrischen Elemente. Die thermoelektrischen Elemente 11 sind dabei unverlierbar mit den Wärmeaustauschaggregaten 10 verbunden, insbesondere dort stoffschlüssig fixiert. Nach Durchströmen dieser Wärmeaustauschaggregate 10 tritt das Abgas wieder in den Abgasaustrittsstutzen 5 aus und strömt (in Fig. 2 nach unten) aus dem Generator 3 hinaus.

In Fig. 2 ist oben links noch eine besondere Zusatzkühlung 22 dargestellt. Dazu wird beispielsweise mittel eines im Abgaseintrittsstutzen 4 angeordneten Sensors 32 die Zusammensetzung und/oder die Temperatur des Abgases gemessen und einer Steuerung 31 zugeführt. Erkennt die Steuerung 31, dass der Betrieb des Generators 3 nicht mehr möglich ist, beispielsweise weil die Temperatur zu hoch ist, und demnach eine Beschädigung der thermoelektrischen Elemente 11 zu befürchten ist, kann die Steuerung 31 auch die Energiezufuhr vom Speicher 30 hin zu den thermoelektrischen Elementen 11 veranlassen, so dass diese nach Art eines Peltier-Elementes eine Kühlung bewirken und somit sich selbst schützen. Eine solche Zusatzkühlung 22 kann besonders schnell zum Einsatz gelangen. Hierfür können gegebenenfalls auch weitere Sensoren 32, insbesondere an den Wärmeaustauschaggregaten 10 vorgesehen sein.

Darüber hinaus ist im Zusammenhang mit der Klappe 20 ein weiteres besonderes Detail angegeben. Die Klappe 20 ist am Einlass 21 mit einer Strömungsverbindung 19 zwischen Abgaseintrittsstutzen 4 und dem gegenüber liegenden Abgasaustrittsstutzen 5 positioniert. Die Klappe 20 ist verschwenkbar, wie dies mit dem schwarzen Pfeil angedeutet ist. Ganz besonders bevorzugt ist, dass die Klappe 20 mittels Federkraft im Wesentlichen senkrecht zur Strömungsrichtung 24 ausgerichtet wird. Erreicht aber nun die Abgasströmung einen bestimmten Druck, wird die Strömungsverbindung 19 geöffnet, in dem die Klappe 20 (von selbst) verschwenkt. Damit ist ein Bypass an dem Wärmeaustauschabschnitt 6 vorbei realisiert. Damit ist insbesondere eine Überlastsicherung gegeben.

Unten rechts ist ein zusätzliches Detail veranschaulicht, das den einfachen Aufbau der Vorrichtung 1 weiter begünstigt. So kann beispielsweise für die Realisierung der Kühleinrichtung 12 auch auf den Kühler 34 einer Abgasrückführung zurückgegriffen werden. Insbesondere ist also hier ein kombiniertes System bestehend aus einem Kühler der Abgasrückführleitung 34 der hier nicht dargestellten Abgasanlage 39 und des thermoelektrischen Generators 3 vorgeschlagen.

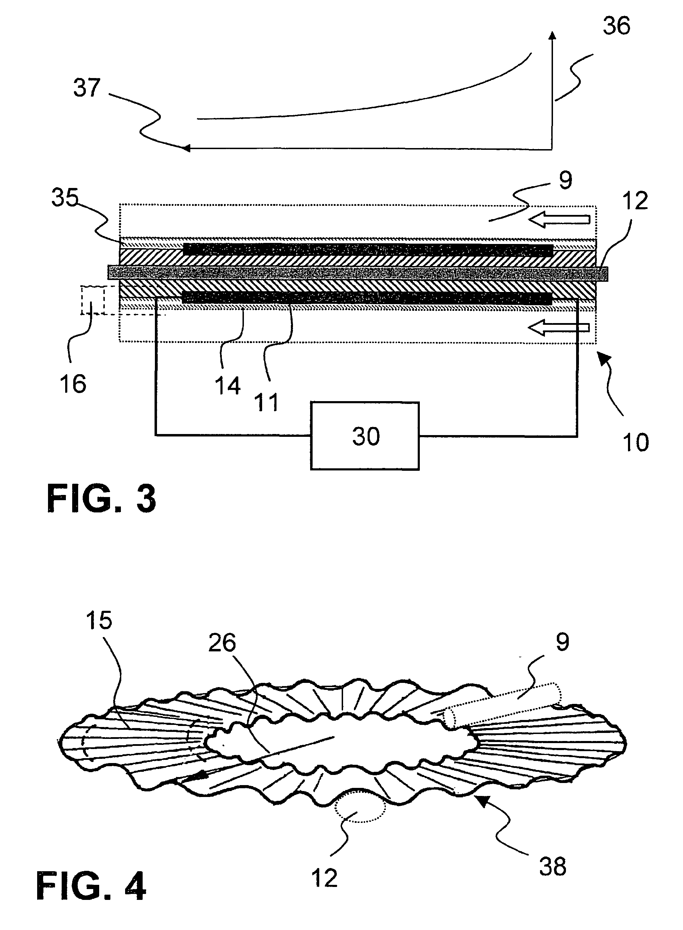

Fig. 3 veranschaulicht schematisch den Aufbau eines Wärmeaustauschaggregats 10. Das Wärmeaustauschaggregat 10 ist benachbart zu beidseits angeordneten Strömungspfaden 9 positioniert, die von heißem Abgas durchströmt werden. Das Wärmeaustauschaggregat 10 umfasst wieder eine interne Kühleinrichtung 12, wobei zwischen der Kühleinrichtung 12 und den Strömungspfaden 9 jeweils ein thermoelektrisches Element 11 vorgesehen ist. Zur unverlierbaren Verbindung von thermoelektrischem Element 11 und der Kühleinrichtung 12 ist hier eine Beschichtung 14 vorgesehen, welche gleichwohl eine hohe Wärmeleitfähigkeit hat. Oben in Fig. 3 ist zudem zur Erläuterung ein Diagramm dargestellt, welches die Temperatur 36 des Abgases über die Länge 37 des Strömungspfads 9 bzw. des thermoelektrischen Elementes 11 veranschaulicht. Die Temperatur gegenüberliegend des thermoelektrischen Elementes 11 ist aufgrund des Kühlmittels deutlich geringer. Dies führt zum so genannten Seebeck-Effekt, so dass vom thermoelektrischen Element 11 Strom abgegriffen werden kann, der einem Speicher 30 zugeführt wird. Um hier insbesondere den direkten Kontakt der thermoelektrischem Elemente 11 (bzw. den Halbleiterelementen) mit dem Abgas zu vermeiden, ist eine Schutzschicht 35 vorgesehen, die die thermoelektrischem Elemente 11 überdeckt.

Für den Fall, dass die Kanäle 9 bildenden Komponenten ein anderes thermisches Ausdehnungsverhalten als das Wärmeaustauschaggregat 10 bzw. die Kühleinrichtung 12 aufweisen, können Kompensatoren 16 vorgesehen sein, die dies ausgleichen. So wird insbesondere verhindert, dass die Kanäle 9 verformt werden und/oder der Anlagekontakt zwischen den Strömungspfaden 9 und den thermoelektrischen Elementen 11 signifikant beschädigt wird.

Fig. 4 zeigt eine Metallfolie 15, die insbesondere zur Begrenzung der Kanäle 9 für das Abgas und/oder der Kanäle für die Kühleinrichtung 12 herangezogen werden kann. Diese Metallfolie 15 weist eine Struktur 38 auf, die in Umfangsrichtung der Metallfolie einander abwechselnde Erhebungen und Senken aufweist, so dass in Richtung des Radius 26 verlaufende Kanäle gebildet sind. Die Kanäle können auch spiralförmig verlaufen, so dass in Richtung des Radius 26 einander abwechselnde Erhebungen und Senken auftreten. Stapelt man mehrere solcher Metallfolien 15 aufeinander, können die Kanäle 9 bzw. die Kühleinrichtung 12 dazwischen ausgeformt werden.

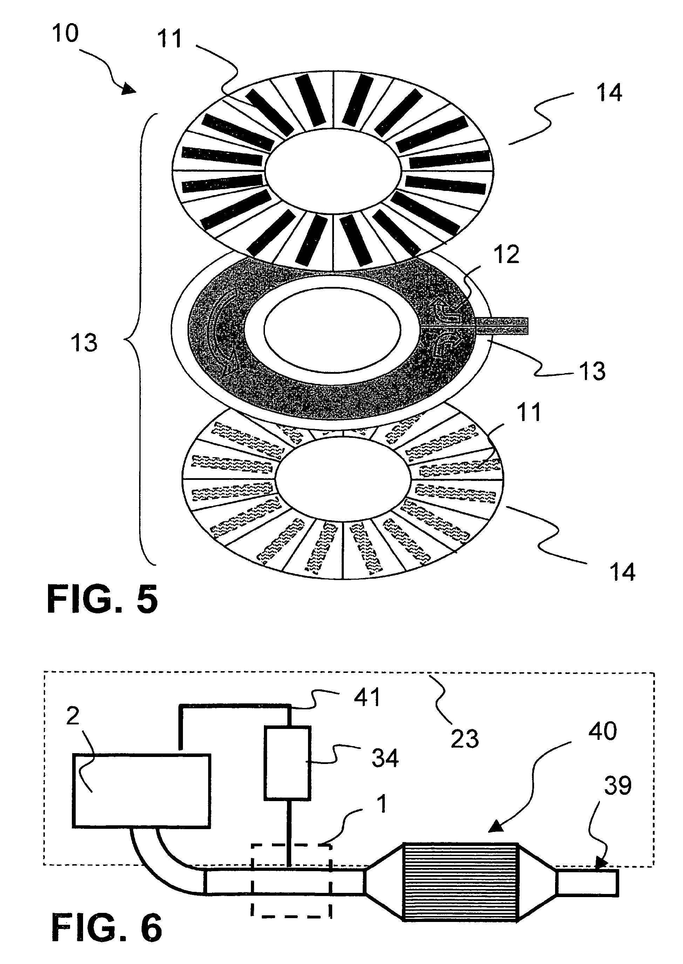

Fig. 5 zeigt schematisch und in einer Explosionsdarstellung einen möglichen Aufbau für ein Wärmeaustauschaggregat 10. Dieses umfasst eine obere Seite 14, die auch in Fig. 5 oben dargestellt ist. Dort ist beispielsweise eine radiale Anordnung der thermoelektrischen Elemente 11, insbesondere bei gleichartiger Ausrichtung der Kanäle 9, realisiert. Dazu weist das Wärmeaustauschaggregat 10 ein zentrales Plattenelement 13 auf, in dem eine Kühleinrichtung 12 ausgeformt ist. Hierzu strömt das Kühlmittel ein, umläuft das Plattenelement 13 in Umfangsrichtung und strömt dann wieder ab. Gleichwohl können auch andere Strömungsrichtungen und/oder Strömungsaufteilungen des Kühlmittels realisiert werden. Auf der gegenüber liegenden unteren Seite 14 sind wiederum die thermoelektrischen Elemente 11 angeordnet, die hier nur gestrichelt dargestellt sind, da sie sich auf der Unterseite befinden.

Fig. 6 veranschaulicht schematisch den bevorzugten Einsatzzweck einer solchen Vorrichtung 1. Dabei ist ein Kraftfahrzeug 23 mit einer Verbrennungskraftmaschine 2 gezeigt. Das in der Verbrennungskraftmaschine 2, beispielsweise einem Ottomotor oder einem Dieselmotor, erzeugt Abgas strömt dann weiter in eine Abgasanlage 39. Dabei ist die erfindungsgemäße Vorrichtung 1 der Verbrennungskraftmaschine 2 in vorteilhafter Weise direkt nachgeschaltet. Sie kann Teil der Abgasanlage 39 selbst sein, gegebenenfalls aber auch Teil einer Abgasrückführung 41, bei der in besonders vorteilhafterweise auf den Kühler 34 zurückgegriffen werden kann. Nach der Behandlung durch den thermoelektrischen Generator 3 kann das Abgas noch einer Abgasbehandlungseinheit 40 zugeführt werden, bevor es gereinigt an die Umgebung abgeleitet wird.

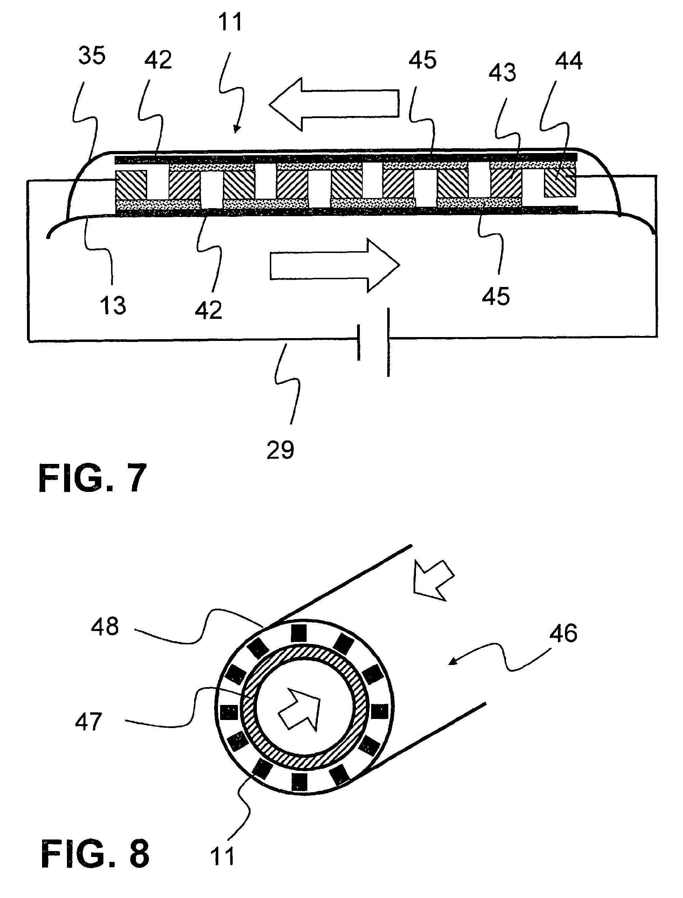

Fig. 7 veranschaulicht eine weitere Ausführung der Erfindung mit einem Schnitt durch eine Ausführungsvariante des oberen Teils der Kühleinrichtung mit dem thermoelektrischen Element 11. Nur der Vollständigkeit halber sei darauf hingewiesen, dass (meist) mehrere thermoelektrische Elemente 11 bei einer Kühlvorrichtung 12 vorgesehen sind, die parallel und/oder in Serie elektrisch geschaltet sind. Ein thermoelektrisches Element 11 ist hier gasdicht zwischen einer Schutzschicht 35 und einem Plattenelement 13 der Kühlvorrichtung 12 angeordnet und stoffschlüssig mit dem Plattenelement 13 verbunden. Das thermoelektrische Element 11 umfasst mehrere paarweise Anordnungen von verschiedenen Halbleiterquadern (p-dotierte Halbleiterquader 44 und n-dotierte Halbleiterquader 43), die auf ihrer Ober- und Unterseite wechselseitig mit metallischen, elektrisch leitenden Brücken 45 verbunden sind. Die Brücken 45 sind auf Keramikplatten 42 angebracht, so dass ein gerichteter Stromfluss über die Brücken 45 gewährleistet ist. Strömt nun heißes Abgas an der Schutzschicht 35 vorbei, heizt sich diese Seite auf, während die gegenüberliegende Seite durch das Kühlmittel gekühlt wird. Damit kann nun gemäß dem Seebeck-Effekt effektiv thermische Energie in elektrische Energie umgewandelt werden.

Fig. 8 veranschaulicht noch ein Detail einer Ausführungsvariante eines Wärmeaustauschaggregates, dass mit mehreren rohrförmigen Elementen 46 ausgestaltet ist. Dabei sind mehrere thermoelektrische Elemente 11 sowohl über den Umfang als auch in axialer Richtung eines jeden rohrförmigen Elements 46 vorgesehen und an der Rohrwandung 47 unverlierbar angeordnet. Nach außen hin werden die thermoelektrischen Elemente 11 von einer Schutzschicht 48 umgeben, die insbesondere einen Kontakt der thermoelektrischen Elemente 11 mit dem Abgas verhindert. Zum Aufbau, der elektrischen Verschaltung, der Strömungsführung, der Materialien, etc. kann vollumfänglich auf die im Zusammenhang mit anderen Ausgestaltungen des Wärmeaustauschaggregates erläuterten Sachverhalte entsprechend zurückgegriffen werden.

### Bezugszeichenliste

- 1: Vorrichtung
- 2: Verbrennungskraftmaschine
- 3: Generator
- 4: Abgaseintrittsstutzen
- 5: Abgasaustrittsstutzen
- 6: Wärmeaustauschabschnitt
- 7: Strömungsumlenkung
- 8: Strömungsaufteilung
- 9: Strömungspfad
- 10: Wärmeaustauschaggregat
- 11: thermoelektrisches Element
- 12: Kühleinrichtung
- 13: Plattenelement
- 14: Seite
- 15: Metallfolie
- 16: Kompensator
- 17: Katalysatorabschnitt
- 18: Leitstruktur
- 19: Strömungsverbindung
- 20: Klappe
- 21: Einlass
- 22: Zusatzkühlung
- 23: Kraftfahrzeug
- 24: Strömungsrichtung
- 25: Achse
- 26: Radius
- 27: Zulauf
- 28: Ablauf
- 29: Strompfad
- 30: Speicher
- 31: Steuerung
- 32: Sensor
- 33: Isolierung
- 34: Kühler für Abgasrückführung
- 35: Schutzschicht
- 36: Temperatur
- 37: Länge
- 38: Struktur
- 39: Abgasanlage
- 40: Abgasbehandlungseinheit
- 41: Abgasrückführung
- 42: Keramikplatte
- 43: n-dotierte Halbleiterquader 43
- 44: p-dotierte Halbleiterquader
- 45: Brücke
- 46: rohrfömiges Element
- 47: Rohrwandung
- 48: Schutzschicht

## Patentansprüche

1. Vorrichtung (1) zur Erzeugung elektrischer Energie aus dem Abgas einer Verbrennungskraftmaschine (2) umfassend einen Generator (3) mit einem Abgaseintrittsstutzen (4) und einem Abgasaustrittsstutzen (5) sowie zumindest einen Wärmeaustauschabschnitt (6) dazwischen, wobei der Wärmeaustauschabschnitt (6) zumindest ein Wärmeaustauschaggregat (10) aufweist, das mit wenigstens einem thennoelektrischen Element (11) und einer Kühleinrichtung (12) ausgeführt ist, wobei das wenigstens eine thermoelektrischen Element (11) mit der Kühleinrichtung (12) unverlierbar verbunden ist, und wobei der zumindest eine Wärmeaustauschabschnitt (6) mit einer Vielzahl von Strömungspfaden (9) quer zum Abgaseintrittsstutzen (4) ausgeführt ist, die mehreren Wärmeaustauschaggregaten (10) zuordenbar sind, wobei zumindest ein Teil der Wärmeaustauschaggregate 10) mit wenigstens einem thermoelektrischen Element (11) und einer Kühleinrichtung (12) ausgeführt ist und wobei die Strömungspfade (9) und die thermoelektrischen Elemente (11) radial angeordnet sind.

2. Vorrichtung (1) gemäß Patentanspruch 1, wobei zwischen dem Abgaseintrittstutzen (4) und dem zumindest einen Wärmeaustauschabschnitt (6) mindestens eine Strömungsumlenkung (7) und/oder mindestens eine Strömungsaufteilung (8) vorgesehen ist.

3. Vorrichtung (1) gemäß einem der vorhergehenden Patentansprüche, bei der Abgaseintrittsstutzen (4) und Abgasaustrittsstutzen (5) gegenüberliegend und die Wärmeaustauschaggregate (10) radial dazu angeordnet sind.

4. Vorrichtung (1) gemäß einem der vorhergehenden Patentansprüche, bei der die Wärmeaustauschaggregate (10) und die Kühleinrichtung (12) mit Plattenelementen (13) und/oder mit rohrförmigen Elementen (46) gebildet sind, auf denen das wenigstens eine thermoelektrische Element (11) positioniert ist.

5. Vorrichtung (1) gemäß Patentanspruch 4, bei der ein Plattenelement (13) mit einer internen Kühleinrichtung (12) und thermoelektrischen Elementen (11) an beiden Seiten (14) hin zu den benachbarten Strömungspfaden (9) ausgeführt ist.

6. Vorichtung (1) gemäß Patentanspruch 4 oder 5, bei der das Plattenelement (13) mit einer Metallfolie (15) gebildet ist, die zumindest ein thermoelektrisches Element (15) aufweist, das von einer Schutzschicht (35) überdeckt ist.

7. Vorrichtung (1) gemäß einem der vorhergehenden Patentansprüche, bei der in dem Wärmeaustauschabschnitt (6) Kompensatoren (16) für Relativbewegungen der Wärmeaustauschaggregate (10) vorgesehen sind.

8. Vorrichtung (1) gemäß einem der vorhergehenden Patentansprüche, bei der der Generator (3) mit einem Katalysatorabschnitt (17) ausgeführt ist, der zumindest teilweise dem Wärmeaustauschabschnitt (6) vorgelagert ist.

9. Vorrichtung (1) gemäß einem der vorhergehenden Patentansprüche, bei der die Strömungsumlenkung (7) eine im Abgaseintrittsstutzen (4) positionierte Leitstruktur (18) ist.

10. Vorrichtung (1) gemäß einem der vorhergehenden Patentansprüche, bei der wenigstens eine einstellbarere Strömungsverbindung (19) von Abgaseintrittsstutzen (4) zum Abgasaustrittsstutzen (5) vorgesehen ist, so dass Abgas zumindest an einem Teil des Wärmeaustauschabschnitts (6) vorbei strömen kann.

11. Vorrichtung (1) gemäß Patentanspruch 10, bei der die wenigstens eine einstellbare Strömungsverbindung (19) eine federvorgespannte und verschwenkbare Klappe (20) am Einlass (21) der Strömungsverbindung (19) ist.

12. Vorrichtung (1) gemäß einem der vorhergehenden Patentansprüche, bei der eine Zusatzkühlung (22) für zumindest einen Teil des Wärmeaustauschabschnitts (6) vorgesehen ist.

13. Kraftfahrzeug (23) aufweisend eine Vorrichtung (1) gemäß einem der vorhergehenden Patentansprüche.

## Claims

1. A device (1) for producing electrical energy from the exhaust gas of an internal combustion engine (2), comprising a generator (3) having an exhaust gas inlet connection (4) and an exhaust gas outlet connection (5) together with at least one heat exchange portion (6) between them, wherein the heat exchange portion (6) comprises at least one heat exchange unit (10), which is designed with at least one thermoelectric element (11) and a cooling device (12), at least one thermoelectric element (11) being captively connected to the cooling device (12), and wherein at least one heat exchange portion (6) is designed with a plurality of flow paths (9) transversely to the exhaust gas inlet connection (4), which paths can be assigned to multiple heat exchange units (10), at least some of the heat exchange units (10) being provided with at least one thermoelectric element (11) and a cooling device (12), and wherein the flow paths (9) and the thermoelectric elements (11) are arranged radially.

2. The device (1) as claimed in claim 1, wherein at least one flow diversion (7) and/or at least one flow division (8) is provided between the exhaust gas inlet connection (4) and at least one heat exchange portion (6).

3. The device (1) as claimed in one of the preceding claims, wherein the exhaust gas inlet connection (4) and the exhaust gas outlet connection (5) are arranged opposite one another and the heat exchange units (10) are arranged radially thereto.

4. The device (1) as claimed in one of the preceding claims, wherein the heat exchange units (10) and the cooling device (12) are formed with plate elements (13) and/or with tubular elements (46), on which at least one thermoelectric element (11) is positioned.

5. The device (1) as claimed in claim 4, wherein a plate element (13) is designed with an internal cooling device (12) and thermoelectric elements (11) on both sides (14) facing the adjacent flow paths (9).

6. The device (1) as claimed in claim 4 or 5, wherein the plate element (13) is formed with a metal foil (15), which comprises at least one thermoelectric element (15) that is covered by a protective layer (35).

7. The device (1) as claimed in one of the preceding claims, wherein compensators (16) for relative movements of the heat exchange units (10) are provided in the heat exchange portion (6).

8. The device (1) as claimed in one of the preceding claims, wherein the generator (3) is designed with a catalytic portion (17), which is arranged at least partially upstream of the heat exchange portion (6).

9. The device (1) as claimed in one of the preceding claims, wherein the flow diversion (7) is a baffle structure (18) positioned in the exhaust gas inlet connection (4).

10. The device (1) as claimed in one of the preceding claims, wherein at least one adjustable flow connection (19) is provided from the exhaust gas inlet connection (4) to the exhaust gas outlet connection (5), so that exhaust gas can flow past at least a part of the heat exchange portion (6).

11. The device (1) as claimed in claim 10, wherein at least one adjustable flow connection (19) is a spring-loaded and pivoted flap (20) on the inlet (21) of the flow connection (19).

12. The device (1) as claimed in one of the preceding claims, wherein an auxiliary cooling (22) is provided for at least a part of the heat exchange portion (6).

13. A motor vehicle (23) comprising a device (1) as claimed in one of the preceding claim.

## Revendications

1. Dispositif (1) de génération d'énergie électrique à partir de gaz d'échappement d'une machine à combustion interne (2), comprenant un générateur (3) avec une connexion d'entrée de gaz d'échappement (4) et une connexion de sortie de gaz d'échappement (5) ainsi qu'au moins une section d'échange de chaleur (6) entre ces derniers, la section d'échange de chaleur (6) comportant au moins une unité d'échange de chaleur (10) qui est pourvue d'au moins un élément thermoélectrique (11) et d'une installation de refroidissement(12), l'au moins un élément thermoélectrique (11) étant relié de façon imperdable avec l'installation de refroidissement (12), et dans quel cas l'au moins une section d'échange de chaleur (6) est réalisée avec une multiplicité de chemins d'écoulement (9) transversalement par rapport à la connexion d'entrée de gaz d'échappement (4), qui peuvent être attribués à une pluralité d'unités d'échange de chaleur (10), au moins une partie des unités d'échange de chaleur (10) étant réalisée avec au moins un élément thermoélectrique (11) et une installation de refroidissement (12) et les chemins d'écoulement (9) et les éléments thermoélectriques (11) étant agencés radialement.

2. Dispositif (1) selon la revendication 1, au moins une déviation-flux (7) et/ou au moins une répartition de flux (8) étant prévue entre la connexion d'entrée de gaz d'échappement (4) et l'au moins une section d'échange de chaleur (6).

3. Dispositif (1) selon l'une des revendications précédentes, dans le cas duquel la connexion d'entrée de gaz d'échappement (4) et la connexion de sortie de gaz d'échappement (5) sont agencées de manière opposée l'une envers l'autre et les unités d'échange de chaleur (10) sont agencées radialement par rapport à ces dernières.

4. Dispositif (1) selon l'une des revendications précédentes, dans le cas duquel les unités d'échange de chaleur (10) et l'installation de refroidissement (12) sont réalisées avec des éléments de plaques (13) et/ou avec des éléments en forme de tubes (46), sur lequel est positionné l'au moins un élément thermoélectrique (11).

5. Dispositif (1) selon la revendication 4, dans le cas duquel un élément de plaque (13) est réalisé avec une installation de refroidissement interne (12) et avec des éléments thermoélectriques (11) sur les deux cotés (14) vers les chemins d'écoulement adjacents (9).

6. Dispositif (1) selon la revendication 4 ou 5, dans le cas duquel l'élément de plaque (13) est formé d'une feuille métallique (15) qui a au moins un élément thermoélectrique (15) qui est recouvert d'une couche protectrice (35).

7. Dispositif (1) selon l'une des revendications précédentes, dans le cas duquel dans la section d'échange de chaleur (6) des compensateurs (16) sont prévus pour des mouvements relatifs des unités d'échange de chaleur (10).

8. Dispositif (1) selon l'une des revendications précédentes, dans le cas duquel le générateur (3) est réalisé avec une section de catalyseur (17) qui est agencé au moins partiellement en amont de la section d'échange de chaleur (6).

9. Dispositif (1) selon l'une des revendications précédentes, dans le cas duquel la déviation de l'écoulement (7) est une structure de tôle (18) positionnée dans la connexion d'entrée de gaz d'échappement (4).

10. Dispositif (1) selon l'une des revendications précédentes, où au moins l'au moins une liaison d'écoulement (19) ajustable étant prévue depuis la connexion d'entrée de gaz d'échappement (4) jusqu'à la connexion de sortie de gaz d'échappement (5), de sorte que le gaz d'échappement puisse s'écouler au moins au passage d'une partie de la section d'échange de chaleur (6).

11. Dispositif (1) selon la revendication 10, dans le cas duquel l'au moins une liaison d'écoulement (19) ajustable est un rabat (20) précontraint par un ressort et pivotable à l'entrée (21) de la liaison d'écoulement (19).

12. Dispositif (1) selon l'une des revendications précédentes, dans le cas duquel un refroidissement supplémentaire (22) pour au moins une partie de la section d'échange de chaleur (6) est prévu.

13. Véhicule automobile (23) comportant un dispositif (1) selon l'une des revendications précédentes.
